# EUROPEAN PATENT APPLICATION

(11) **EP 2 172 978 A2**
(43) Date of publication of application: **07.04.2010**
(21) Application number: 09152642.6
(22) Date of filing: 12.02.2009
(51) Int. Cl.: H01L 31/0224, H01L 31/18

(54) **Structure of solar cell panel and manufacturing method of electrode of solar cell panel**

(30) Priority: 19.09.2008 TW 97136116
(71) Applicant: Gintech Energy Corporation, Miaoli County 350, Taiwan (CN)
(72) Inventor: Chang, Kai-Sheng, 328, Taoyuan County (TW); Ou, Nai-Tien, 328, Taoyuan County (TW); Chen, Tien-Szu, 328, Taoyuan County (TW)
(74) Representative: Lang, Christian

(57) **Abstract**

A manufacturing method of an electrode of a solar cell panel of the present invention comprises the steps of providing a semiconductor substrate with an antireflection layer/a dielectric layer and a first metal layer in sequence, forming a first metal layer on the antireflection layer, projecting a pattern on the first metal layer by a laser beam to form a metal silicide on the semiconductor substrate in accordance with the outline of the pattern, removing the first metal layer by a chosen solution, forming a first electrode connecting to the metal silicide and exposed to a surface of the antireflection layer; and forming a second electrode on a surface of the semiconductor substrate opposite to the antireflection layer.

## Description

### BACKGROUND

### Field of Invention

The present invention relates to a manufacturing method of an electrode of a solar cell panel, more particularly to a manufacturing method of electrode of solar cell panel using desired patterns displayed with laser beam.

### Description of Related Art

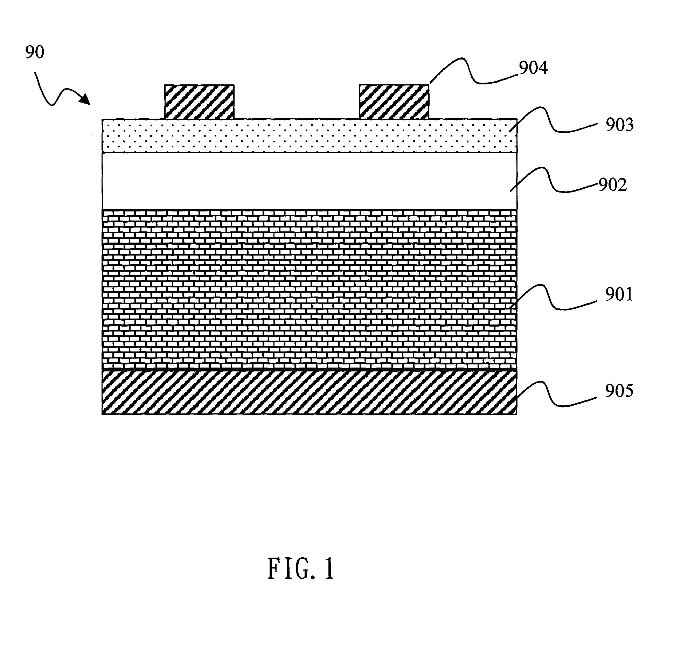

A conventional art of manufacturing a solar cell often includes the steps of: (1) crystal pulling process: silica is adopted as a main material, a crystal seed is placed in a crystal pulling furnace for obtaining an ingot; (2) edge trimming process: a wafer used in general micro electronic industries is that the ingot is directly processed with a cutting operation, but for a solar cell, plural chips are arranged as a rectangular matrix, in order to tighten the rectangular matrix, the ingot is often trimmed to a rectangular shape; (3) sliding process: a slider is used to cut the ingot into wafers with 0.5 mm in thickness; (4) etching and polishing processes: the etching process is to eliminate strained layers formed during the sliding process, the polishing process is to reduce the possibilities that particles adhere on the wafers; (5) rinsing process, DI water is used to remove contaminants on the surfaces of the wafers; (6) diffusion process (as shown in FIG. 1): a p-type substrate 901 is often adopted in a general solar cell, and a thermal diffusion treatment is processed so a thin layer of n-type semiconductor 902 is formed on the p-type substrate 901. Before the diffusion process is operated, the surface is roughened for obtaining a rough texturing structure and an antireflection layer 903 is provided for reducing the amount of light reflection; (7) screen printing process: an Ag glue and an Al glue are coated on the finished wafer and two surfaces of the wafer are printed with a pre-determined pattern by a screen printing machine with respect to a silk sheet; (8) synchronize sintering process: the wafer printed with the Ag glue and the Al glue is placed in a thermal sintering furnace so a hypereutectic structure is respectively formed between the Ag glue and the corresponding surface of the wafer and between the Al glue and the corresponding surface of the wafer, and an ohmic contact is defined between the glues and the surfaces of the wafer, so conductive electrodes 904, 905 are able to be provided on the surfaces of the wafer, a simple solar cell panel is therefore obtained.

Whenever a wafer is processed with a screen printing process, various kinds of pre-determined patterns are in sequence provided on a silk sheet. After the fabrication of the silk sheet is finished, patterns on the silk sheet are printed on the wafer by a screen printing machine.

The procedure of fabricating a silk sheet for screen printing is complex and time consuming and labor intensive, the cost, without a doubt, is high, so massive production has to be conducted to proportioning the fabrication cost to each finished product. But for a small-amount production or for customized products, the cost of silk sheet fabrication is a burden for the proportioned production cost, therefore the averaging selling price (ASP) is not able to be lowered, a less competitiveness in the marketplace is occurred.

### SUMMARY

One object of the present invention is to provide a pattern of a conductive electrode on a surface of a wafer via a laser beam, and the wafer is processed with an alloy treatment via the laser beam, so the above mentioned processes of screen printing and sintering are able to be disregarded, time and production cost are therefore saved.

Another object of the present invention is to provide an application of laser projection capable of rapidly modifying a pattern, so a customized pattern of a conductive electrode can be freely modified or changed, so customers have more pattern choices.

One another object of the present invention is to replace the screen printing process and the silk sheet fabrication with a laser beam capable of providing a pattern of a conductive electrode on a surface of a wafer, so manufacturing cost of small numbers of product or customized products is cut down to further lower the unit cost of each product.

One another object of the present invention is to reduce resistance value of a conductive electrode for raising efficiency of current yielding for a solar cell.

According to the above-mentioned objects of the present invention, the present invention provides a manufacturing method of electrode of solar cell panel, comprising a step of providing a semiconductor substrate with an antireflection layer thereon, the semiconductor substrate comprising a P-type doping layer and a N-type doping layer that are stacked with each other; a step of forming a first metal layer on the antireflection layer; a step of projecting a pattern on the first metal layer by a laser beam to process an alloy treatment through the first metal layer and the antireflection layer to form a metal silicide on the semiconductor substrate in accordance with the outline of the pattern; a step of removing the first metal layer by a chosen solution; a step of forming a first electrode connecting to the metal silicide and exposed on a surface of the antireflection layer; and a step of forming a second electrode on a surface of the semiconductor substrate opposite to the antireflection layer.

The present invention also provides a structure of solar cell panel, comprising a semiconductor substrate, an antireflection layer, a metal silicide, a first electrode and a second electrode. The semiconductor substrate includes a P-type doping layer and an N-type doping layer that are stacked with each other. The antireflection layer is disposed on the P-type doping layer or on the N-type doping layer of the semiconductor substrate. The first electrode is disposed in the antireflection layer and is exposed to a surface of the antireflection layer. The metal silicide is disposed on the P-type doping layer or the N-type doping layer, and the metal silicide is connected to the first electrode. The second electrode is disposed on a surface of the semiconductor substrate opposite to the antireflection layer.

### BRIEF DESCRIPTION OF THE DRAWINGS

The structure and the technical means adopted by the present invention to achieve the above and other objects can be best understood by referring to the following detailed description of the preferred embodiments and the accompanying drawings, where:
FIG. 1 is a structure schematic view of a panel fabricated via prior arts;
FIG. 2 is a flowchart of a preferred embodiment of the present invention;
FIG. 3A to FIG 3K are structure schematic views of steps illustrated in FIG. 2.

### DESCRIPTION OF THE PREFERRED EMBODIMENTS

Hereinafter a structure of a first characteristic of the present invention covers or is provided on top of a second characteristic, this may include an embodiment wherein the first characteristic and the second characteristic are in direct contact, or include another embodiment wherein another characteristic is provided between the first characteristic and the second characteristic so the first characteristic and the second characteristic are not in direct contact.

The described processes of screen printing and sintering are disregarded by the present invention, and the present invention discloses a solar cell panel and a manufacturing method of electrode of the panel, which applies a way of displaying an electrode pattern by a laser beam so as to form a metal silicide. That is, according to a desired pattern of the conductive electrode, a laser beam is emitted by a laser generating device and is projected on a surface of a wafer, and the laser beam is controlled via various parameters and performs an alloy treatment on the wafer, so after the alloy treatment, a conductive electrode having the desired pattern is obtained. So the present invention provides a manufacturing method of conductive electrode of solar cell panel that can meet the needs of customization and rapid or various requirements.

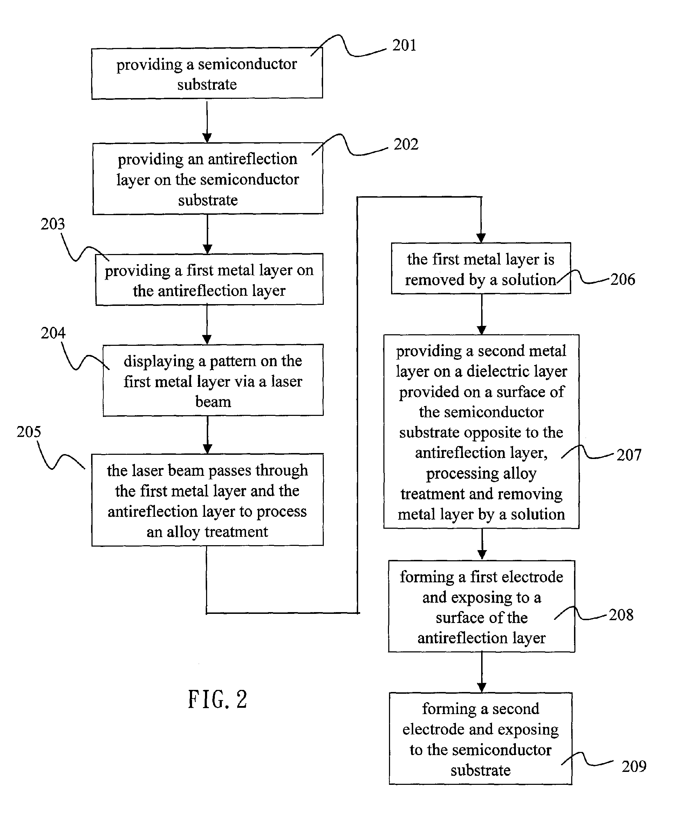

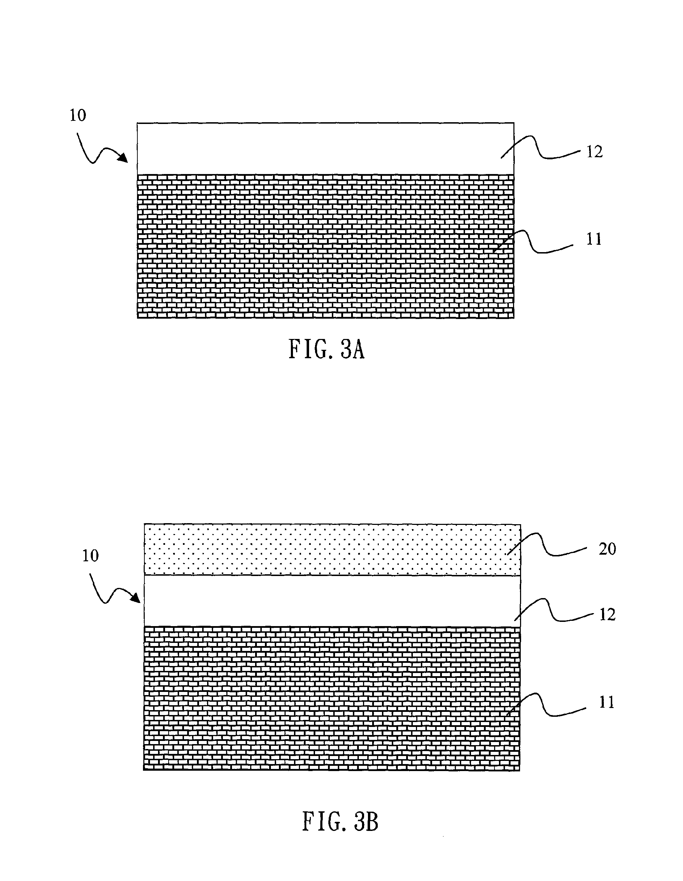

Referring to FIG. 2, which is a flowchart of a preferred embodiment of the present invention. The manufacturing method of electrode of solar cell panel provided by the present invention includes the following steps.
Step 201: providing a semiconductor substrate 10 (as shown in FIG. 3A)
The semiconductor substrate 10 includes a P-type doping layer 11 and a N-type doping layer 12, and the P-type doping layer 11 is stacked with the N-type doping layer 12, and the material of which the semiconductor substrate 10 is made is not limited to single crystal silicon, polycrystal- silicon or amorphous silicon.
Step 202: providing an antireflection layer 20 (or a dielectric layer) on the semiconductor substrate 10 (as shown in FIG. 3B)

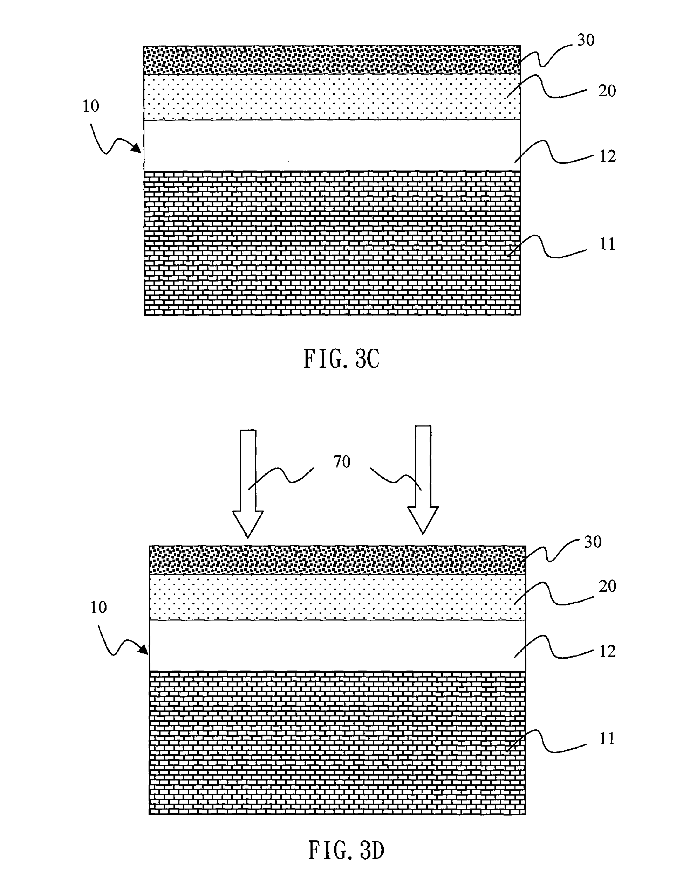

The antireflection layer 20 (or the dielectric layer) can be made of nitride, oxide or other multi-layer film (e.g.TiO2/A2O3) being inter-stacked and the antireflection layer 20 is formed on the semiconductor substrate 10 via a way of coating. Although, the antireflection layer 20 in this embodiment is provided on the N-type doping layer 12 as illustrated on the figure, the antireflection layer 20 in fact is not limited to be provided on the N-type doping layer 12 or the P-type doping layer 11.
Step 203: providing a first metal layer 30 on the antireflection layer 20 (as shown in FIG. 3C)

In this step, the first metal layer 30 can be provided on the antireflection layer 20 via a way of evaporation or deposition, and the first metal layer 30 can be made of, for example, titanium (Ti), cobalt (Co), wolfram (W), platinum (Pt), hafnium (Hf), tantalum (Ta), molybdenum (Mo), chromium (Cr), palladium (Pd), gold (Au), silver (Ag), copper (Cu) or aluminum (Al) etc.. In this embodiment, although Ti is adopted for making the first metal layer 30 as an illustration for the present invention, the material of which the first metal layer 30 is made is not limited to the metals mentioned above.
Step 204: displaying a pattern on the first metal layer 30 via a laser beam 70 (as shown in FIG. 3D)

According to a desired pattern of a conductive electrode requested by customers, e.g. text, trademark, decorative design or other images having various purposes, one or more laser beams 70 are generated by a laser generating device and are vertically projected on the first metal layer 30 for arranging the pattern of the conductive electrode.

Whenever customers want to modify patterns or order only a small amount of panels, an operation of fabricating a silk sheet with respect to a desired pattern is not needed any more; instead, a computer software is used for editing patterns with respect to the customers' requests, so a desired pattern of a conductive electrode is immediately obtained, and the pattern is able to be modified or changed at any time.

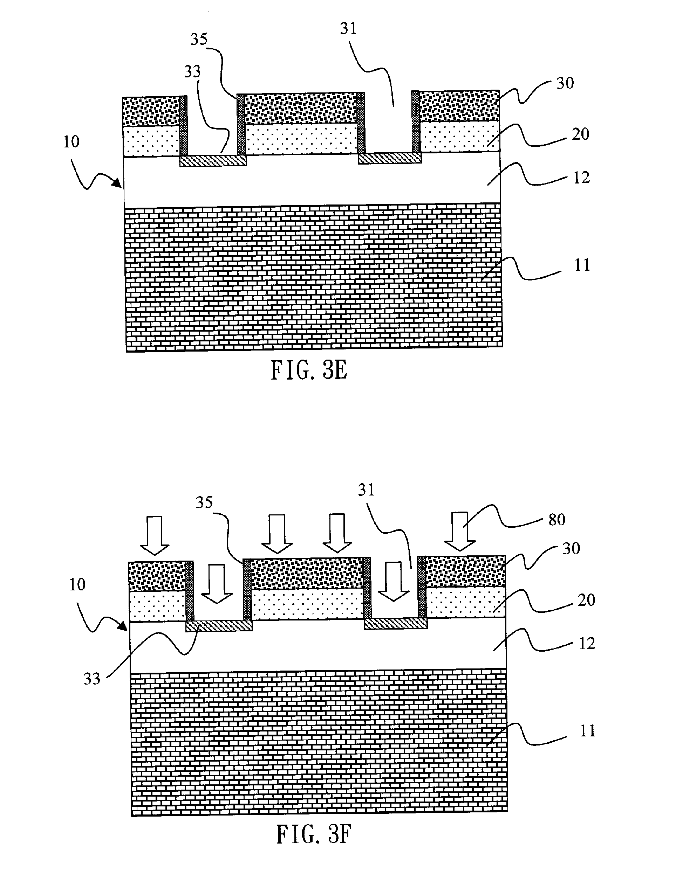

Step 205: according to the outline of the pattern, the laser beam 70 passes through the first metal layer 30 and the antireflection layer 20 to process an alloy treatment (as shown in FIG. 3E)

At this step, because properties of the laser beam 70 (e.g. generating high temperature), when the laser beam 70 projects the pattern on the first metal layer 30, an alloy treatment is processed through the first metal layer 30 and the antireflection layer 20 with respect to the outline of the described pattern. After the laser beam 70 passes through the first metal layer 30 and the antireflection layer 20, and forms a concave area 31 extending from the first metal layer 30 to the antireflection layer 20 and closing to the semiconductor substrate 10, a hypereutectic structure is generated on the semiconductor substrate 10 (either on the P-type doping layer 11 or the N-type doping layer 12), and then a metal silicide 33 (in this embodiment said metal silicide is TiSi2) and a metal compound 35 (metal nitride or metal oxide, in this embodiment said metal compound is TiN) are formed in the concave area 31, wherein the metal silicide 33 is provided at a bottom surface of the concave area 31, and the metal compound 35 surrounds inner walls of the concave area 31 defined by the first metal layer 30 and the antireflection layer 20. In other words the metal silicide 33 is disposed on the semiconductor substrate 10 (the p-type doping layer 11 or the n-type doping layer 12) with respect to the outline of the pattern.

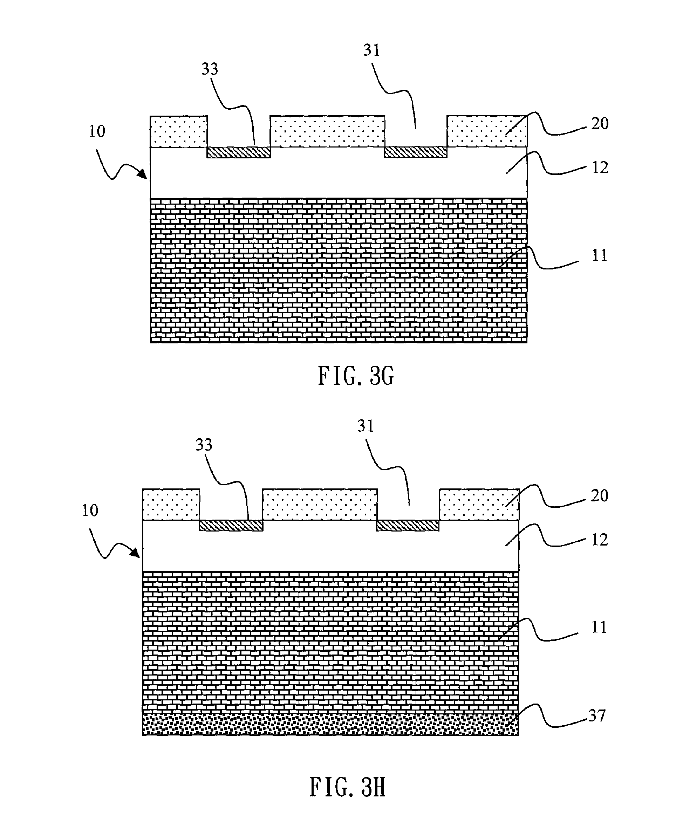

For different materials of which the antireflection layer 20 is made and the thickness of the antireflection layer 20 and different materials of which the first metal 30 layer is made and the thickness of the first metal layer 30, various kinds of lasers (e.g. red light, green light or ultraviolet light) with different powers, frequencies, penetration depths and processing time can be adopted. For example in the embodiment, the first metal layer 30 made of titanium, a multimode laser beam 70 is used in this embodiment, the laser beam 70 is not limited to a pulsed or a continued laser beam 70, the frequency thereof is between 10 kHz - 150 kHz, the power thereof is for example at least 50 milliwatt which is enough to penetrate through the antireflection layer 20, and the thickness of the antireflection layer 20 is for example between 10 nano - 400 nano.
Step 206: removing the first metal layer 30 by a chosen solution (as shown in FIG. 3F and FIG. 3G)

In this step, the fraction of the first metal layer 30 without alloy treatment process is removed by a way of chemical wet etching. Particularly, a metal etching solution 80 is chosen depending on the property of the first metal layer 30 to remove residuals of the first metal layer 30 on the antireflection layer 20 as well as the metal compound 35 surrounding the inner walls of the concave area 31.

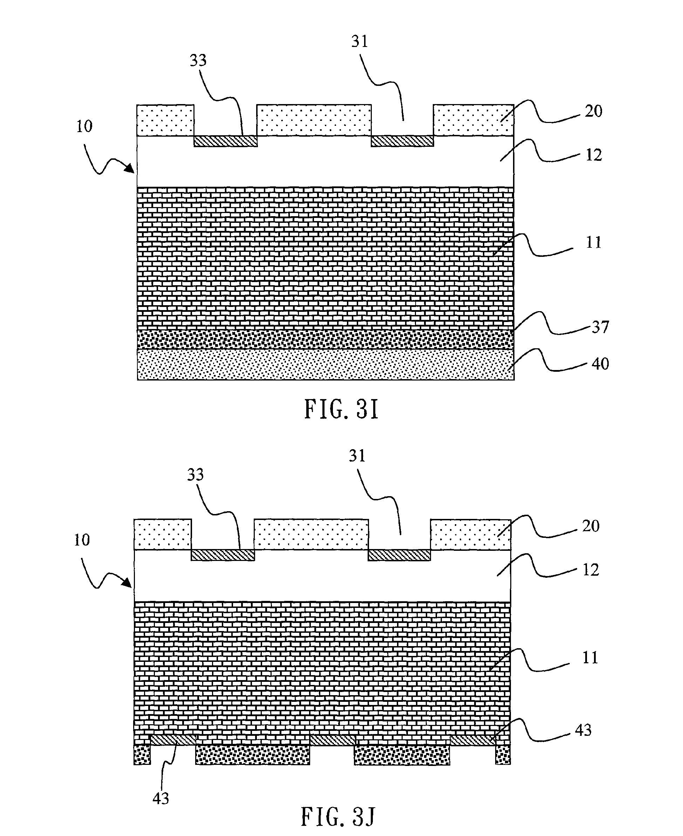

Because different materials of which the fist metal layer 30 is made react with different metal etching solutions 80, for the described metals, for Cr the corresponding metal etching solution 80 can be a water solution of Ce(N03)2 and HN03, for W the corresponding metal etching solution 80 can be 3HCL/H2O2, for Pd the corresponding metal etching solution 80 can be Kl/l2, and the material property of the metal silicide 33 is different from that of the first metal layer 30 so the metal silicide 33 is not removed during this removing operation. In this embodiment, the material of which the first metal layer 30 is made is titanium, so the metal etching solution 80 can be chosen for NH4OH/H2O2.
Step 207: providing a second metal layer 40 on a surface of the semiconductor substrate 10 opposite to the antireflection layer 20 (as shown in FIG. 3H, FIG. 3I and FIG. 3J)

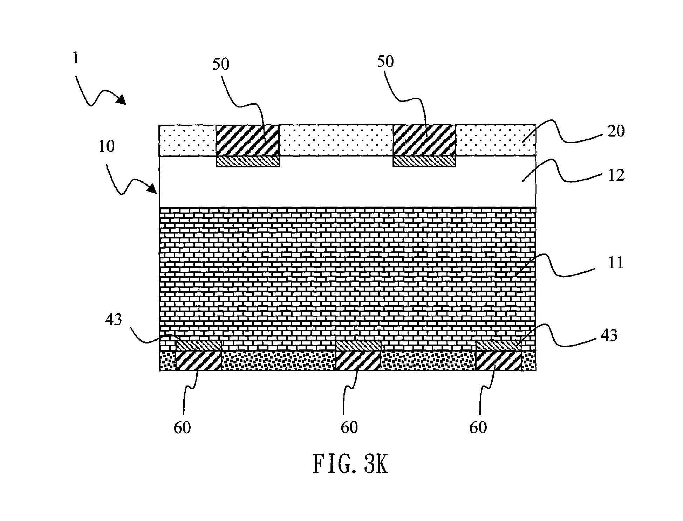

The second metal layer 40 can be provided on the surface of the semiconductor substrate 10 (on the n-type doping layer 12 or the p-type doping layer 11) opposite to the antireflection layer 20 by either the process in the Step 203 or the described screen printing process. When the other surface of the semiconductor substrate 10 is operated with the Step 203∼Step 204 for manufacturing an electrode, a dielectric layer 37 is needed to be provided for preventing the whole surface being coated during the electroplating operation and for avoiding current leaking, so in the Step 207 of this embodiment, the dielectric layer 37 is provided on the surface of the semiconductor substrate 10 opposite to the surface where the antireflection layer 20 is provided, wherein the dielectric layer 37 is for example thinner than 2 micrometer, then the second metal layer 40 is provided on the dielectric layer 37, then the above mentioned Step 204 to the Step 206 are processed. Another pattern is displayed on the second metal layer 40 via the laser beam 70, after the laser beam 70 penetrates the dielectric layer 37, then another metal silicide 43 is therefore obtained, another chosen solution is used to remove residuals of the second metal layer 40 so a structure as shown in FIG. 3J is obtained.
Step 208: forming a first electrode 50 for connecting to the metal silicide 33 and exposing the first electrode 50 to the surface of the antireflection layer 20 (as shown in FIG. 3K)

In this step, the metal silicide 33 has a property of electrical conduction so the first electrode 50 is able to be formed on the metal silicide 33 provided inside the concave area 31, and the first electrode 50 is exposed outside of the surface of the antireflection layer 20 for being served as a conductive electrode of a solar cell; wherein a means for forming the first electrode 50 can be electro plating, electroless plating, chemical plating or auto-catalytic plating.
Step 209: forming a second electrode 60 and exposing the second electrode 60 to the semiconductor substrate 10 (on the n-type doping layer 12 or the p-type doping layer 11 and is provided on a surface of the semiconductor substrate 10 opposite to the surface where the antireflection layer 20 is provided) (as shown in FIG. 3K)

A manufacturing method of the second electrode 60 can be the same as the first electrode 50 disclosed at the Step 208 for being connected to another metal silicide 43 or when the second metal layer 40 is operated with a screen printing process, a synchronize sintering process is operated for directly forming the second electrode 60.

With the above mentioned steps, the structure of the solar cell panel provided by the present invention is obtained, and an alloy treatment is operated on the first metal layer 30 and on the antireflection layer 20. Comparing with a conductive electrode formed after operating a screen printing and a sintering processes, the generated metal silicide 33 of the present invention is more unified, and by controlling parameters of the laser beam 70, contact resistance of the conductive electrode is further lowered, preferably to a value of 10⁻⁸ Ω/cm², so a current generating efficiency of a solar cell is increased.

It is to be understood, however, that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A manufacturing method of an electrode of a solar cell panel, comprising:
providing a semiconductor substrate with an antireflection layer thereon, the semiconductor substrate comprising a P-type doping layer and an N-type doping layer that are stacked with each other;
forming a first metal layer on the antireflection layer;
projecting a pattern on the first metal layer by a laser beam to process an alloy treatment through the first metal layer and the antireflection layer to form a metal silicide on the semiconductor substrate in accordance with the outline of the pattern;
removing the first metal layer by a chosen solution;
forming a first electrode connecting to the metal silicide and exposed on a surface of the antireflection layer; and
forming a second electrode on a surface of the semiconductor substrate opposite to the antireflection layer.

2. The manufacturing method of an electrode of a solar cell panel as claimed in claim 1, wherein between removing the first metal layer and forming the first electrode, it further comprises:
providing a dielectric layer to a surface of the semiconductor substrate opposite to the antireflection layer;
providing a second metal layer on the dielectric layer;
projecting another pattern on the second metal layer by a laser beam to process an alloy treatment through the second metal layer to form another metal silicide on the semiconductor substrate in accordance with the outline of the another pattern for connecting to the second electrode; and
removing the second metal layer by another chosen solution.

3. The manufacturing method of an electrode of a solar cell panel as claimed in claim 1, wherein the first metal layer is provided on the antireflection layer by a way of evaporation or deposition.

4. The manufacturing method of an electrode of a solar cell panel as claimed in claim 1, when processing the alloy treatment through the first metal layer and the antireflection layer by the laser beam, it further comprises:
passing through the first metal layer and the antireflection layer to define a concave area by the laser beam, wherein the metal silicide is provided at the bottom end of the concave area and on the semiconductor substrate;
forming a metal compound surrounding the first metal layer and the antireflection layer with respect to inner walls of the concave area after the metal silicide is provided; and
simultaneously removing the first metal layer and the metal compound through chemical wet etching by the solution being chosen to be a metal etching solution.

5. The manufacturing method of an electrode of a solar cell panel as claimed in claim 4, wherein the material of which the first metal layer is made is selected from the group consisting of Ti, Co, W, Pt, Hf, Ta, Mo, Cr, Pd, Au, Ag, Cu and Al.

6. The manufacturing method of an electrode of a solar cell panel as claimed in claim 5, wherein the metal etching solution is chosen to be NH4OH/H2O2 when the first metal layer is made of titanium.

7. The manufacturing method of an electrode of a solar cell panel as claimed in claim 5, wherein the metal etching solution is chosen to be a water solution of Ce(N03)2 and HN03 when the first metal layer is made of Cr.

8. The manufacturing method of an electrode of a solar cell panel as claimed in claim 5, wherein the metal etching solution is chosen to be 3HCL/H2O2 when the first metal layer is made of W.

9. The manufacturing method of an electrode of a solar cell panel as claimed in claim 5, wherein the metal etching solution is chosen to be Kl/l2 when the first metal layer is made of Pd.

10. The manufacturing method of an electrode of a solar cell panel as claimed in claim 1, wherein the first electrode is provided on the metal silicide by a way of electro plating, electroless plating, chemical plating or auto-catalytic plating.

11. The manufacturing method of an electrode of a solar cell panel as claimed in claim 1, wherein the second electrode is provided on the metal silicide by a way of electro plating, electroless plating, chemical plating or auto-catalytic plating.

12. The manufacturing method of an electrode of a solar cell panel as claimed in claim 1, wherein the antireflection layer is provided on the P-type doping layer.

13. The manufacturing method of an electrode of a solar cell panel as claimed in claim 1, wherein the antireflection layer is provided on the N-type doping layer.

14. A method of forming metal silicide by displaying an electrode pattern via laser beam, which is implemented on an electrode manufacturing procedure for solar cell, the method includes:
providing a P-type doping layer and a N-type doping layer that are stacked with each other;
providing an antireflection layer on the N-type doping layer;
forming a first metal layer on the antireflection layer;
displaying a pattern on the first metal layer via plural laser beams vertically projecting to the first metal layer, and processing an alloy treatment through the first metal layer and the antireflection layer and penetrating the antireflection to form a metal silicide on a surface of the n-type doping layer in accordance with the outline of the pattern; and
removing the first metal layer by a metal etching solution.

15. A structure of solar cell panel, comprising:
a semiconductor substrate comprising a p-type doping layer and a n-type doping layer that are stacked with each other;
an antireflection layer disposed on the semiconductor substrate;
a first electrode disposed in the antireflection layer and exposed to a surface of the antireflection layer;
a metal silicide disposed in either the P-type doping layer or the N-type doping layer, and connected to the first electrode; and
a second electrode disposed on a side of the semiconductor substrate opposite to the antireflection layer.

16. The structure of solar cell panel as claimed in claim 15, wherein the P-type doping layer is adjacent to the antireflection layer.

17. The structure of solar cell panel as claimed in claim 15, wherein the N-type doping layer is adjacent to the antireflection layer.

18. The structure of solar cell panel as claimed in claim 15, wherein the metal silicide is TiSi2.

19. The structure of solar cell panel as claimed in claim 15, wherein the second electrode is disposed on a dielectric layer provided on a surface of the semiconductor substrate opposite to the antireflection layer.
